(19) Europäisches Patentamt / European Patent Office / Office européen des brevets

(11) **EP 3 062 065 A1**

(12) **EUROPEAN PATENT APPLICATION**
published in accordance with Art. 153(4) EPC

(43) Date of publication:
**31.08.2016 Bulletin 2016/35**

(21) Application number: **14855792.9**

(22) Date of filing: **01.08.2014**

(51) Int Cl.:
$G01C\ 3/06\ ^{(2006.01)}$     $G02B\ 7/28\ ^{(2006.01)}$
$G02B\ 7/34\ ^{(2006.01)}$     $G03B\ 13/36\ ^{(2006.01)}$
$G06T\ 1/00\ ^{(2006.01)}$     $H04N\ 5/232\ ^{(2006.01)}$
$H04N\ 9/07\ ^{(2006.01)}$

(86) International application number:
**PCT/JP2014/070303**

(87) International publication number:
**WO 2015/059970 (30.04.2015 Gazette 2015/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.10.2013 JP 2013220023**

(71) Applicant: **Olympus Corporation**
**Tokyo 192-8507 (JP)**

(72) Inventor: **IMADE, Shinichi**
**Tokyo 192-8507 (JP)**

(74) Representative: **Gunzelmann, Rainer**
**Wuesthoff & Wuesthoff**
**Patentanwälte PartG mbB**
**Schweigerstraße 2**
**81541 München (DE)**

(54) **IMAGING DEVICE AND PHASE DIFFERENCE DETECTION METHOD**

(57)     An imaging device includes an imaging section (10) that captures a first object image and a second object image that have parallax with respect to an identical object, and a phase difference detection section (30) that calculates a correlation coefficient between a first image in which the first object image is captured, and a second image in which the second object image is captured, and detects the phase difference between the first image and the second image based on the correlation coefficient. The phase difference detection section (30) subjects the pixel value of the first image and the pixel value of the second image to a normalization process, calculates the average value of the pixel value of the first image and the pixel value of the second image that have been subjected to the normalization process, and calculates the correlation coefficient based on a value obtained by adding up the values obtained by subjecting the pixel value of the first image and the pixel value of the second image that have been subjected to the normalization process to a subtraction process within a fall interval in which the average value decreases, and a value obtained by adding up the values obtained by subjecting the pixel value of the first image and the pixel value of the second image that have been subjected to the normalization process to the subtraction process within a rise interval in which the average value increases.

FIG. 3

**Description**

TECHNICAL FIELD

The present invention relates to an imaging device, a phase difference detection method, and the like.

BACKGROUND ART

A method that compares two waveforms that are shifted in position (i.e., have a phase difference) to detect the phase difference is an important technique that is indispensable for a wide range of fields such as a parallax level (amount) detection process used for a stereo image 3D measurement process, and a phase difference detection process necessary for a control process (PLL control process) that adjusts the phase of an electrical signal to that of a reference signal.

Normally, the matching position is determined while shifting two similar comparison target waveforms, and the difference (shift amount) between the original position and the matching position is detected as the phase difference. A normalized cross-correlation calculation method (e.g., zero-mean normalized cross-correlation (ZNCC) method), a method that utilizes the sum of absolute differences (SAD), and the like have been proposed as a matching evaluation method that calculates the phase difference between two similar waveforms.

Such a matching evaluation process is affected by noise included in the comparison target waveforms (as described later). For example, Patent Literature 1 discloses a method that reduces the effects of noise by removing a noise component from the comparison target waveforms that include noise (i.e., the search target image and the template image in Patent Literature 1) through an estimation process. According to the method disclosed in Patent Literature 1, a micro-area within the target image is arbitrarily selected, and the variance within the selected micro-area is approximately calculated to be the variance of noise. Since a change in signal component is small (i.e., the signal component has an almost constant value) within the micro-area, the estimated variance is considered to approximately represent the variance of noise. A noise component is removed from the comparison target waveforms using the variance to define the matching evaluation value.

CITATION LIST

PATENT LITERATURE

Patent Literature 1: JP-A-2001-22941

SUMMARY OF INVENTION

TECHNICAL PROBLEM

When using a known matching evaluation method (e.g., ZNCC or SAD), when the comparison target waveforms have a similar shape in the amplitude direction, the correlation coefficient has a maximum or minimum peak value in principle at a position at which the normalized comparison target waveforms coincide with each other.

However, when a degradation factor that reduces the similarity between the comparison target waveforms is added to the comparison target waveforms, the evaluation value does not necessarily have a maximum or minimum peak value at a position at which the comparison target waveforms coincide with each other. For example, since the degradation factor such as random noise changes each time the image is detected, the phase difference detection position indicated by the maximum or minimum peak value includes a variation in error with respect to the correct position. Since the detection position variation range due to a variation in error corresponds to the matching position detection resolution or detection accuracy, the matching position detection resolution or detection accuracy is significantly affected by the degradation factor when using a known matching evaluation method.

Several aspects of the invention may provide an imaging device, a phase difference detection method, and the like that can reduce a variation in error with regard to phase difference detection.

SOLUTION TO PROBLEMS

According to one aspect of the invention, there is provided an imaging device comprising:

an imaging section that captures a first object image and a second object image that have parallax with respect to an identical object; and

a phase difference detection section that calculates a correlation coefficient between a first image in which the first object image is captured, and a second image in which the second object image is captured, and detects a phase difference between the first image and the second image based on the correlation coefficient,

wherein the phase difference detection section subjects a pixel value of the first image and a pixel value of the second image to a normalization process, calculates an average value of the pixel value of the first image and the pixel value of the second image that have been subjected to the normalization process, and calculates the correlation coefficient based on a value obtained by adding up values obtained by subjecting the pixel value of the first image and the pixel value of the second image that have been subjected to the normalization process to a subtraction process within a fall interval in which the average value decreases, and a value obtained by adding up values obtained by subjecting the pixel value of the first image and the pixel value of the second image that have been subjected to the normalization process to the subtraction process within a rise interval in which the average value increases.

According to another aspect of the invention, there is provided a phase difference detection method comprising:

capturing a first object image and a second object image that have parallax with respect to an identical object;
subjecting a pixel value of a first image and a pixel value of a second image to a normalization process, the first image being an image in which the first object image is captured, and the second image being an image in which the second object image is captured;
calculating an average value of the pixel value of the first image and the pixel value of the second image that have been subjected to the normalization process;
calculating a correlation coefficient based on a value obtained by adding up values obtained by subjecting the pixel value of the first image and the pixel value of the second image that have been subjected to the normalization process to a subtraction process within a fall interval in which the average value decreases, and a value obtained by adding up values obtained by subjecting the pixel value of the first image and the pixel value of the second image that have been subjected to the normalization process to the subtraction process within a rise interval in which the average value increases; and
detecting a phase difference between the first image and the second image based on the correlation coefficient.

BRIEF DESCRIPTION OF DRAWINGS

FIG. 1 is a view illustrating the effects of a degradation factor on a matching evaluation process.
FIG. 2 illustrates a configuration example of an imaging device.
FIG. 3 is a view illustrating an improved SAD matching evaluation process.
FIG. 4 illustrates simulation results for the statistical variance of a phase difference detection value with respect to the SN ratio of waveforms.
FIG. 5 illustrates a configuration example of an imaging device according to a second embodiment.
FIG. 6 is a view illustrating the basic principle of a stereo image measurement method that utilizes a pupil division technique.
FIG. 7 illustrates a configuration example of an imaging device according to a third embodiment.
FIG. 8 illustrates an example of the spectral characteristics of a pupil division filter and an image sensor.
FIG. 9 is a view illustrating a densification process.
FIGS. 10A to 10D are views illustrating a densification process.
FIG. 11 is a view illustrating a densification process.
FIGS. 12A to 12C illustrate simulation results for a phase difference detection process using a densification process.
FIG. 13 is a view illustrating a densification process.
FIG. 14 illustrates sampling data similarity simulation results.
FIG. 15 is a view illustrating a modification of a normalization method.

DESCRIPTION OF EMBODIMENTS

Exemplary embodiments of the invention are described in detail below. Note that the following exemplary embodiments do not in any way limit the scope of the invention defined by the claims laid out herein. Note also that all of the elements described below in connection with the exemplary embodiments should not necessarily be taken as essential elements of the invention.

1. Outline

A degradation factor may be added to the comparison target waveforms that are subjected to the matching evaluation process. Examples of the degradation factor include random noise, quantization noise, deterioration in similarity between the comparison target waveforms (that occurs when the point spread functions of two pupils are asymmetric), crosstalk between the comparison target waveforms, and the like. An example in which random noise is added as the degradation factor is discussed below. Although an example in which the comparison target waveforms are those of a stereo image is described below, the matching evaluation method according to several embodiments of the invention can be applied to the case where two signal waveforms having a phase difference are compared.

When using a known matching evaluation method (e.g., ZNCC or SAD), a matching position detection error may occur due to the degradation factor, and it may be difficult to obtain high detection resolution or detection accuracy.

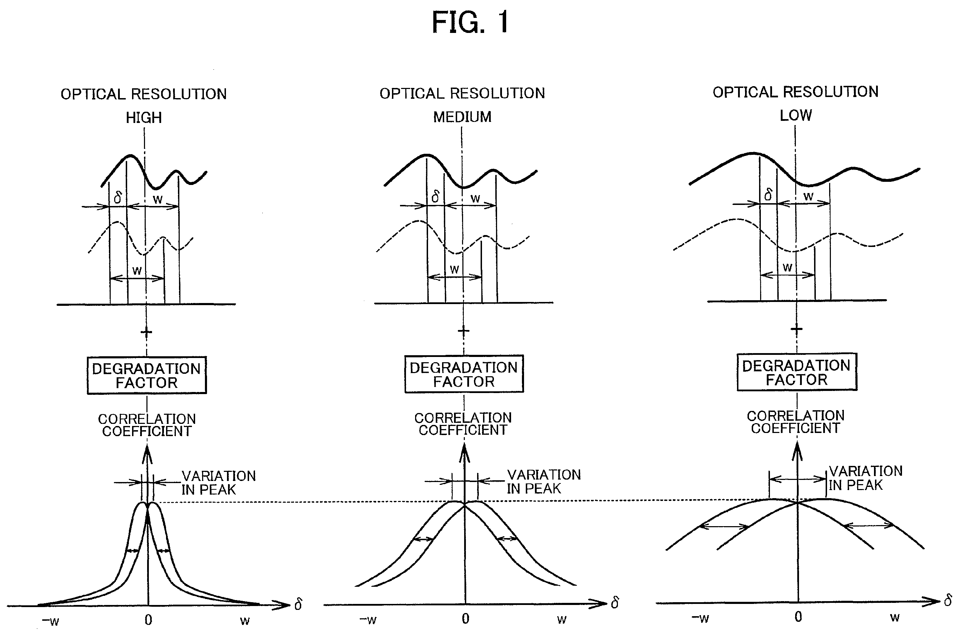

As illustrated in FIG. 1, the effects of noise more significantly occur as the frequency component of the comparison target waveforms decreases in frequency. Specifically, since the correlation coefficient of the comparison target waveforms of images that have low optical resolution corresponds to the waveform of a low-frequency component, the correlation coefficient shows a small difference between the peak and the values around the peak. Therefore, a variation in peak significantly increases when noise is added, and it becomes difficult to determine the true peak value. Therefore, noise is significantly disadvantageous when it is desired to calculate the phase difference with high accuracy.

When calculating the phase difference, the comparison target waveforms do not necessarily include a high-frequency component. For example, when performing a stereo image 3D measurement process, the comparison target waveforms include a large amount of high-frequency component at the in-focus position, but include only a low-frequency component at a relatively defocus position (i.e., a position at which a defocus state occurs). When implementing a 3D measurement process, since it is necessary to calculate the phase difference within a given measurement range in the depth direction, it is necessary to also use a defocused image. Therefore, it is necessary to calculate the accurate phase difference even when the comparison target waveforms include only a low-frequency component. It is important to eliminate the effects of noise as much as possible in order to implement a highly accurate phase difference detection process.

The method disclosed in Patent Literature 1 removes the estimated noise from the comparison target waveforms. However, since noise is estimated from the comparison target waveforms to which a signal component and noise are added, it may be difficult to achieve high estimation accuracy. The estimation process disclosed in Patent Literature 1 is performed on the assumption that a signal component has an almost constant value in a micro-area within an image. However, such a condition may not be satisfied in an area in which a change in contrast occurs to a large extent. Therefore, part of a signal component may be erroneously estimated to be a noise component, and it may be difficult to implement a highly accurate matching detection process.

As described above, it is important to detect the correct matching position while eliminating the effects of noise when implementing the phase difference detection process.

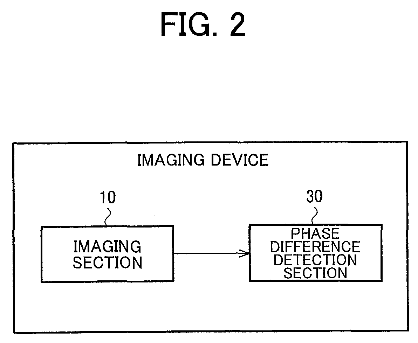

As illustrated in FIG. 2, an imaging device according to several embodiments of the invention includes an imaging section 10 that captures a first object image and a second object image that have parallax with respect to an identical object, and a phase difference detection section 30 that calculates a correlation coefficient between a first image in which the first object image is captured, and a second image in which the second object image is captured, and detects the phase difference between the first image and the second image based on the correlation coefficient.

The phase difference detection section 30 subjects the pixel value of the first image and the pixel value of the second image to a normalization process, calculates the average value of the pixel value of the first image and the pixel value of the second image that have been subjected to the normalization process, and calculates the correlation coefficient based on a value obtained by adding up the values obtained by subjecting the pixel value of the first image and the pixel value of the second image that have been subjected to the normalization process to a subtraction process within a fall interval in which the average value decreases, and a value obtained by adding up the values obtained by subjecting the pixel value of the first image and the pixel value of the second image that have been subjected to the normalization process to a subtraction process within a rise interval in which the average value increases.

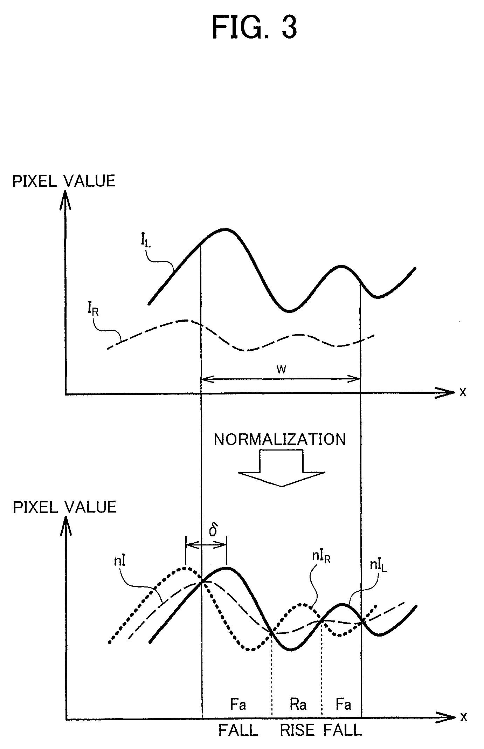

In the first embodiment described later, a left-pupil image $I_L$ and a right-pupil image $I_R$ (see FIG. 3) respectively correspond to the first image and the second image, and are subjected to the normalization process to calculate a left-pupil image $nI_L$ and a right-pupil image $nI_R$. The left-pupil image $nI_L$ and the right-pupil image $nI_R$ (obtained by the normalization process) are subjected to the subtraction process within each of a fall interval Fa in which the average value $nI$ decreases and a rise interval Ra in which the average value $nI$ increases (see the expressions (4) and (6)). The values obtained by the subtraction process are added up corresponding to each interval, and the resulting values are added up to calculate a correlation coefficient ISAD.

It is possible to change the order of subtraction so that a signal subtractive value D obtained by subjecting the comparison target waveforms to the subtraction process has a positive value corresponding to each interval (see the expressions (3) and (5)) by adding up the values obtained by subjecting the left-pupil image $nI_L$ and the right-pupil image

$nI_R$ to the subtraction process corresponding to each of the fall interval Fa and the rise interval Ra. Note that the values obtained by subjecting the left-pupil image $nI_L$ and the right-pupil image $nI_R$ to the subtraction process may be added up corresponding to each interval, and the absolute value of the resulting value may be calculated so that the subtractive value D has a positive value (see the expression (13)).

When the correlation coefficient ISAD is calculated as described above, the signal component included in the comparison target waveforms is represented by the sum of absolute differences (i.e., the sum of $|I_R-I_L|$), and the noise component included in the comparison target waveforms is represented by the sum of differences (i.e., the sum of $n_R-n_L$) (see the expression (9)). Therefore, the noise component is reduced by the effect of addition. It is possible to implement a phase difference detection process that reduces a variation in error and achieves high resolution or high accuracy by evaluating a position at which the correlation coefficient ISAD becomes a minimum as the matching position. Note that the above method is hereinafter referred to as "improved SAD".

2. First embodiment

2.1. Improved SAD matching method

The details of the improved SAD are described below. The imaging device is configured in the same manner as illustrated in FIG. 2. An example in which the pupil of a monocular imaging optical system is divided into a left pupil and a right pupil to generate a left-pupil image (that is used as the first image) and a right-pupil image (that is used as the second image) that have parallax is described below. Note that the configuration according to the first embodiment is not limited thereto. For example, the first embodiment may also be applied to the case where a binocular imaging section is used.

FIG. 3 is a view illustrating an improved SAD (improved sum of absolute differences) matching evaluation process (i.e., a matching evaluation process that utilizes the improved SAD).

$I_L$ indicates the partial profile (waveform pattern) of the captured left-pupil image, and $I_R$ indicates the partial profile (waveform pattern) of the captured right-pupil image. Specifically, $I_L$ and $I_R$ indicate the pixel value patterns of the parallax images (formed on the image sensor by light that has passed through the left pupil and light that has passed through the right pupil) in the horizontal direction x (parallax direction). The pupil image $I_L$ and the pupil image $I_R$ have a phase difference $\delta$.

Since the pupil image $I_L$ and the pupil image $I_R$ differ in amplitude gain, a normalization process is performed using a value within a given calculation interval w (i.e., an interval used to calculate the correlation coefficient) to adjust the amplitude gain. The normalized pupil image $nI_L$ and the normalized pupil image $nI_R$ are calculated by the following expression (1). Note that "w" attached to the sigma notation represents that the sum is calculated within the range of the given calculation interval w.

$$nI_R = \frac{I_R}{\sqrt{\sum^w I_R^2}}, \quad nI_L = \frac{I_L}{\sqrt{\sum^w I_L^2}} \quad (1)$$

The normalized pupil image $nI_L$ and the normalized pupil image $nI_R$ are added up to generate a composite waveform nI (see the following expression (2)).

$$nI = nI_R + nI_L \quad (2)$$

The cross points of the pupil image $nI_L$ and the pupil image $nI_R$ are detected within the given calculation interval w, and the interval between the adjacent cross points is calculated. An interval in which the composite waveform nI has a tendency to rise is referred to as "rise interval Ra", and an interval in which the composite waveform nI has a tendency to fall is referred to as "fall interval Fa" For example, the differential value between the adjacent pixels of the composite waveform nI within the interval defined by the adjacent cross points is integrated, and the interval is determined to be the rise interval when the integral value is positive, and determined to be the fall interval when the integral value is negative.

A subtractive value D is calculated corresponding to the rise interval Ra and the fall interval Fa while changing the order of subtraction of the pupil image $I_L$ and the pupil image $I_R$ (see the following expression (3)). Specifically, the order of subtraction is determined so that "subtractive value D>0" in each interval.

$$\text{Ra:} \quad nI_R > nI_L \quad \therefore D = nI_R - nI_L > 0 \\ \text{Fa:} \quad nI_R < nI_L \quad \therefore D = nI_L - nI_R > 0 \quad \Big\} \quad (3)$$

The calculated subtractive values D are added up within the given calculation interval w (see the following expression (4)) to calculate an ISAD evaluation value (matching evaluation coefficient). Note that "Ra" and "Fa" attached to the sigma notation represent that the sum is calculated corresponding to each of the ranges Ra and Fa within the given calculation interval w. When no cross point is present within the given calculation interval w, whether the given calculation interval w is the rise interval or the fall interval is determined, and the ISAD evaluation value is calculated corresponding to the given calculation interval w.

$$\text{ISAD} = \sum^{\text{Ra}} (nI_R - nI_L) + \sum^{\text{Fa}} (nI_L - nI_R) \qquad (4)$$

The positions of the pupil image $I_L$ and the pupil image $I_R$ in the rightward-leftward direction differ between a front-focus state and a rear-focus state. When the left-pupil image $I_L$ is shifted to the left relative to the right-pupil image $I_R$, differing from the example illustrated in FIG. 3, the subtractive value D is calculated using the following expression (5) since the magnitude relationship between the normalized pupil image $nI_L$ and the normalized pupil image $nI_R$ differs from that illustrated in FIG. 3. The ISAD evaluation value is calculated using the following expression (6).

$$\text{Ra:} \quad nI_R < nI_L \quad \therefore D = nI_L - nI_R > 0 \\ \text{Fa:} \quad nI_R > nI_L \quad \therefore D = nI_R - nI_L > 0 \quad \Big\} \quad (5)$$

$$\text{ISAD} = \sum^{\text{Ra}} (nI_L - nI_R) + \sum^{\text{Fa}} (nI_R - nI_L) \qquad (6)$$

The magnitude relationship between the pupil image $nI_L$ and the pupil image $nI_R$ is determined by comparing the pixel value of the pupil image $nI_L$ and the pixel value of the pupil image $nI_R$ within each of the interval Ra and the interval Fa, for example. The expression (4) or the expression (6) is selected based on the determination result, and the ISAD evaluation value is calculated.

In the first embodiment, whether each interval is the rise interval or the fall interval is determined, and the sum of differences is calculated for the pupil image $I_L$ and the pupil image $I_R$ for the following reasons instead of calculating the sum of absolute differences for the pupil image $I_L$ and the pupil image $I_R$ without determining whether each interval is the rise interval or the fall interval (i.e., known SAD method). Note that the normalized waveform is also hereinafter referred to as "$I_L$", "$I_R$", or the like.

Suppose that the waveform patterns $I_L$ and $I_R$ are waveform patterns having very high similarity. A waveform obtained by adding a noise component $n_L$ to the waveform pattern $I_L$ is referred to as $I_L$', and a waveform obtained by adding a noise component $n_R$ to the waveform pattern $I_R$ is referred to as $I_R$' (see the following expression (7)).

$$I_L' = I_L + n_L \\ I_R' = I_R + n_R \quad \Big\} \quad (7)$$

The following expression (8) represents the case where a known SAD matching evaluation process is applied to the waveform $I_L$' and the waveform $I_R$'.

$$\text{SAD} = \sum^{w} |I_R' - I_L'| = \sum^{w} |(I_R - I_L) + (n_R - n_L)|$$

$$\leq \sum^{w} \{|I_R - I_L| + |n_R - n_L|\} \qquad (8)$$

The SAD evaluation value becomes 0 when the comparison target waveforms coincide with each other. However, the maximum value of the SAD evaluation value is obtained by calculating the sum of the sum of absolute differences between the waveform $I_L$ and the waveform $I_R$ and the sum of absolute differences between the noise component $n_R$ and the noise component $n_L$ (see the expression (8)). The noise component $n_R$ and the noise component $n_L$ may be random noise. Since the absolute value is used, the noise component $n_R$ and the noise component $n_L$ do not counterbalance each other even when added up. This means that the SAD evaluation value includes a large amount of noise component even when the waveform $I_L$ and the waveform $I_R$ coincide with each other (i.e., $|I_L-I_R|=0$). Specifically, since the SAD evaluation value does not necessarily become a minimum even when $|I_L-I_R|=0$, it is impossible to determine the correct matching position. Specifically, the SAD evaluation value is very easily affected by noise.

On the other hand, the relationship represented by the following expression (9) is obtained by applying the expression (7) to the ISAD evaluation value defined by the expression (4).

$$\text{ISAD} = \sum^{\text{Ra}}\{(I_R + n_R) - (I_L + n_L)\} + \sum^{\text{Fa}}\{(I_L + n_L) - (I_R + n_R)\}$$

$$= \sum^{w}|I_R - I_L| + \sum^{w}(n_R - n_L) \qquad (9)$$

The ISAD evaluation value is calculated by calculating the sum of the sum of absolute differences between the waveform $I_L$ and the waveform $I_R$ and the sum of differences between the noise component $n_R$ and the noise component $n_L$. The sum of absolute differences between the waveform $I_L$ and the waveform $I_R$ becomes 0 ($|I_L-I_R|=0$) when the waveform $I_L$ and the waveform $I_R$ coincide with each other. The sum of differences between the noise component $n_R$ and the noise component $n_L$ decreases due to the effect of addition of random noise since the absolute value is not used. The sign of the difference between the noise components differs between the interval Ra and the interval Fa, but does not affect the effect of addition since the noise component is random noise. Therefore, the matching position of the waveform $I_L$ and the waveform $I_R$ can be evaluated using the ISAD evaluation value in a state in which noise is significantly reduced. Specifically, the ISAD evaluation value makes it possible to implement a matching evaluation process that is not easily affected by noise, and the ISAD evaluation method is superior to the SAD evaluation method.

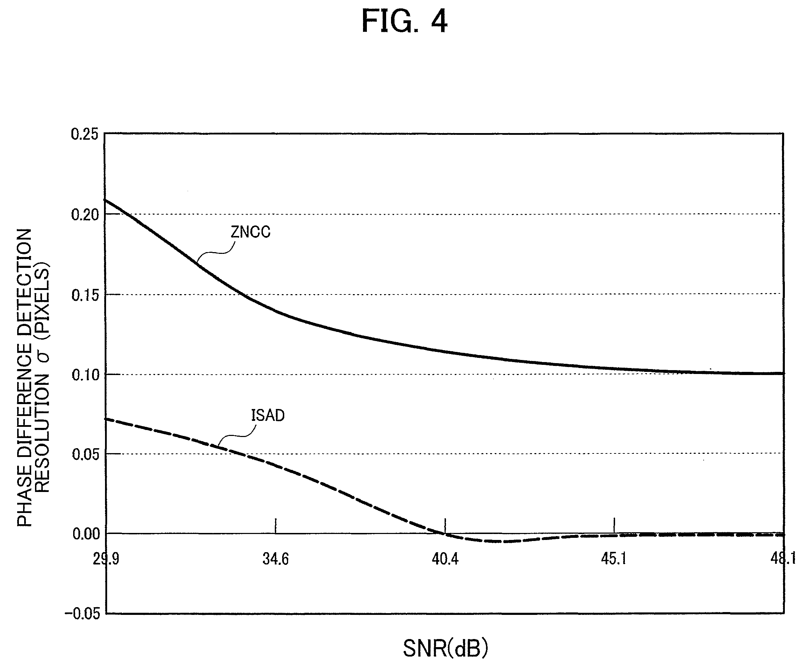

FIG. 4 illustrates the simulation results for the statistical variance $\sigma$ of the phase difference detection value with respect to the SN ratio (SNR) of the waveform $I_L$' and the waveform $I_R$'-

An edge waveform is used as the waveform $I_L$' and the waveform $I_R$'. The phase difference when the matching evaluation value becomes a maximum (peak value) is used as the phase difference detection value. The variance $\sigma$ is calculated as described below. Specifically, the waveform $I_L$' and the waveform $I_R$' are generated while randomly changing the appearance pattern of noise having an identical power. The matching process is performed a plurality of times using the waveform $I_L$' and the waveform $I_R$' to calculate the phase difference. An error between the phase difference and the true value of the phase difference between the waveform $I_L$ and the waveform $I_R$ is calculated, and the variance $\sigma$ is calculated from the distribution of the occurrence of the error.

FIG. 4 also illustrates the variance $\sigma$ when using a correlation coefficient calculated using the zero-mean normalized cross-correlation (ZNCC) method. It is obvious that the error variation $\sigma$ of the phase difference detection value when using the ISAD evaluation value is smaller than the error variation $\sigma$ of the phase difference detection value when using the ZNCC evaluation value with respect to the same SN ratio. Specifically, the ISAD evaluation value is not easily affected by noise, and achieves high phase difference detection resolution.

For example, when the correlation calculation process is performed on low-frequency images, a variation in correlation peak increases if a degradation factor such as noise is applied, and the phase difference detection accuracy deteriorates. According to the first embodiment, however, since the variation $\sigma$ in correlation peak is small as compared with the case of using a known method even when noise is applied, it is possible to implement a highly accurate phase difference detection process.

Note that it is possible to effectively implement a more accurate phase difference detection process by combining the improved SAD with the second embodiment or the third embodiment described later. In such a case, the imaging device is configured in the same manner as in the second embodiment or the third embodiment. In the third embodiment, the phase difference fine detection section 70 performs the phase difference detection process according to the first embodiment.

According to the first embodiment, the phase difference detection section 30 calculates the intersections of the pixel value of the first image $nI_L$ and the pixel value of the second image $nI_R$ (obtained by the normalization process) within a given interval w (given calculation interval) along the epipolar line of the first image $I_L$ (left-pupil image) and the second image (right-pupil image) to determine a plurality of intervals that are included in the given interval w and defined by the intersections, sets an interval among the plurality of intervals in which the average value nI increases to be the rise interval Ra, and sets an interval among the plurality of intervals in which the average value nI decreases to be the fall interval Fa.

According to this configuration, the rise interval Ra in which the average value nI increases and the fall interval Fa in which the average value nI decreases can be determined from the average value nI of the pixel value of the first image $nI_L$ and the pixel value of the second image $nI_R$ (obtained by the normalization process). It is possible to add up the subtractive values corresponding to each interval (see the expression (4), (6), and (13)) by setting the rise interval Ra and the fall interval Fa, and calculate the improved SAD evaluation value.

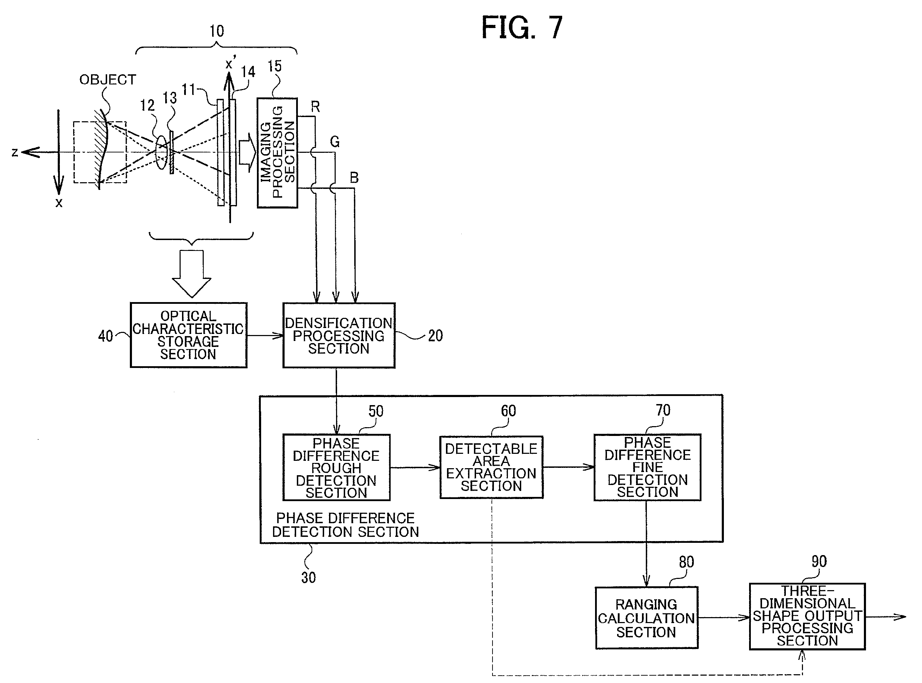

The term "epipolar line" used herein refers to a straight line that is used to search two stereo images for the corresponding points. Specifically, the epipolar line is obtained by projecting a line of sight that corresponds to a point within one image onto the other image. When searching the other image for a point that corresponds to a point within the one image, the search range is limited to a range situated on the epipolar line. When the pupil of a monocular imaging optical system is divided in the horizontal scan direction (parallel stereo) (see FIG. 7), the epipolar line corresponds to the horizontal scan line.

According to the first embodiment, the phase difference detection section 30 determines the magnitude relationship between the pixel value of the first image $nI_L$ and the pixel value of the second image $nI_R$ that have been subjected to the normalization process corresponding to each of the fall interval Fa and the rise interval Ra (see the expressions (3) and (5)). The phase difference detection section 30 subjects the pixel value of the first image $nI_L$ and the pixel value of the second image $nI_R$ that have been subjected to the normalization process to the subtraction process corresponding to each interval based on the determined magnitude relationship so that the values D obtained by the subtraction process are positive values, and adds up the values obtained by the subtraction process to calculate the correlation coefficient ISAD (see the expressions (3) to (6)).

According to this configuration, it is possible to determine the magnitude relationship between the waveform of the first image $nI_L$ and the waveform of the second image $nI_R$ corresponding to each of the rise interval Ra and the fall interval Fa (see the expressions (3) and (5)), and determine the order of waveform subtraction using the quantitative relationship so that the subtractive value D has a positive value corresponding to each interval. This makes it possible to allow the signal component $|I_R-I_L|$ of the correlation coefficient ISAD to remain as the sum of absolute differences, and reduce the noise component $(n_R-n_L)$ as the sum of differences by utilizing the effect of addition (see the expression (9)).

2.2. Modification of normalization process

The normalization process (method) used for the pupil image $I_L$ and the pupil image $I_R$ is not limited to the normalization process represented by the expression (1). For example, the normalization process may be performed as described below.

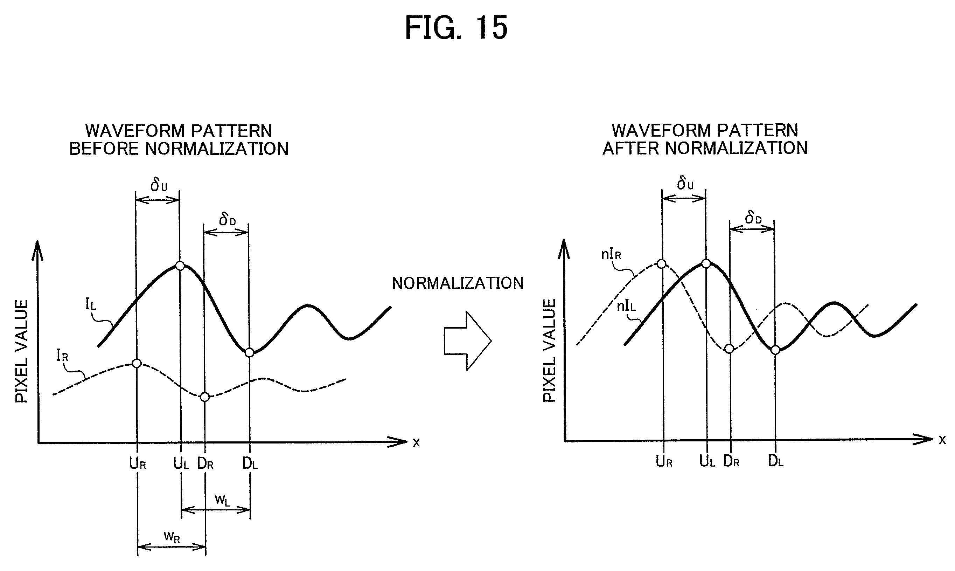

The left side in FIG. 15 illustrates the partial profile (waveform pattern) of the left-pupil image $I_L$ and the partial profile (waveform pattern) of the right-pupil image $I_R$. When implementing the matching evaluation method (ISAD) according to the first embodiment, it is necessary to normalize the level of the left-pupil image $I_L$ and the level of the right-pupil image $I_R$ that differ from each other to obtain the waveform patterns illustrated on the right side in FIG. 15.

For example, a gain correction process is performed on the right-pupil image $I_R$ within an interval $w_R$. For example, the left-pupil image $I_L$ and the right-pupil image $I_R$ have a similar waveform within the interval w, and the shift amounts $\delta_U$ and $\delta_D$ are very small. In this case, it is obvious that the pixel value of the right-pupil image $I_R$ at the x-position $U_R$ (upper peak) corresponds to the pixel value of the left-pupil image $I_L$ at the x-position $U_L$ (upper peak). It is also obvious that the pixel value of the right-pupil image $I_R$ at the x-position $D_R$ (lower peak) corresponds to the pixel value of the left-pupil image $I_L$ at the x-position $D_L$ (lower peak).

Therefore, the peak positions $U_R$, $D_R$, $U_L$, and $D_L$ are calculated. The average value Av(R) is calculated within the range of the peak positions $U_R$ and $D_R$, and the average value Av(L) is calculated within the range of the peak positions $U_L$ and $D_L$ (see the following expression (10)).

$$Av(R) = \frac{\sum_{x=U_R}^{D_R} I_R}{w_R}, \quad Av(L) = \frac{\sum_{x=U_L}^{D_L} I_L}{w_L} \quad (10)$$

A correction gain is calculated from the average value Av(R) and the average value Av(L), and the normalization process is performed within the interval $w_R$ using the following expression (11). The left-pupil image $I_L$ and the right-pupil image $I_R$ thus have waveform patterns having the same level (see the right side in FIG. 15).

$$nI_R = \frac{Av(L)}{Av(R)} \times I_R, \qquad nI_L = I_L \qquad (11)$$

Note that the normalization expression is not limited to the expression (11). For example, the normalization process may be performed on both the left-pupil image $I_L$ and the right-pupil image $I_R$ (see the following expression (12)).

$$nI_R = \frac{I_R}{Av(R)}, \qquad nI_L = \frac{I_L}{Av(L)} \qquad (12)$$

In either case, since the left-pupil image $I_L$ and the right-pupil image $I_R$ are normalized by performing the gain correction process on the intervals (intervals $w_R$ and $w_L$) in which matching occurs, the matching evaluation value can be obtained by comparing the waveforms having the same level. Moreover, it is possible to utilize the relationship between the adjacent peaks when calculating the phase difference in a state in which the left-pupil image $I_L$ and the right-pupil image $I_R$ are close to each other, and the shift amount is very small.

2.3. Second ISAD evaluation value calculation method

The ISAD evaluation value calculation method is not limited to the expressions (4) and (6). For example, the following expression (13) may be used.

$$ISAD = \left| \sum^{Ra} (nI_R - nI_L) \right| + \left| \sum^{Fa} (nI_L - nI_R) \right| \qquad (13)$$

According to the expression (13), the phase difference detection section 30 adds up the values obtained by subjecting the pixel value of the first image $nI_L$ (left-pupil image) and the pixel value of the second image $nI_R$ (right-pupil image) that have been subjected to the normalization process to the subtraction process within the fall interval Fa, and calculates the absolute value of the resulting value. The phase difference detection section 30 adds up the values obtained by subjecting the pixel value of the first image $nI_L$ and the pixel value of the second image $nI_R$ that have been subjected to the normalization process to the subtraction process within the rise interval Ra, and calculates the absolute value of the resulting value. The phase difference detection section 30 adds up the absolute value that corresponds to the fall interval Fa and the absolute value that corresponds to the rise interval Ra to calculate the correlation coefficient ISAD.

The value obtained by subjecting the pupil images $nI_R$ and $nI_L$ is either a positive value or a negative value within the rise interval Ra or the fall interval Fa. A positive value or a negative value is obtained by integrating the value obtained by subjecting the pupil images $nI_R$ and $nI_L$ within each interval. The ISAD evaluation value similar to that calculated using the expressions (4) and (6) can be obtained by calculating the absolute value of the resulting value. According to this method, it is unnecessary to change the order of subtraction when subjecting the pupil images $nI_R$ and $nI_L$ to the subtraction process since the resulting value may be a negative value.

For example, the magnitude relationship between the pupil images $nI_R$ and $nI_L$ differs between the case where the left-pupil image $nI_L$ is shifted to the right with respect to the right-pupil image $nI_R$ and the case where the left-pupil image $nI_L$ is shifted to the left with respect to the right-pupil image $nI_R$. Therefore, it is necessary to determine the magnitude relationship between the pupil images $nI_R$ and $nI_L$ within each interval, and adaptively change the order of subtraction. However, it is unnecessary to change the order of subtraction by utilizing the expression (13).

3. Second embodiment

A second embodiment of the invention is described below. In the second embodiment, a densification process with regard to the sampling pitch is performed by image processing, and an accurate phase difference detection process is performed using high-density parallax images. It is possible to implement a more accurate phase difference detection process by applying the improved SAD (see above).

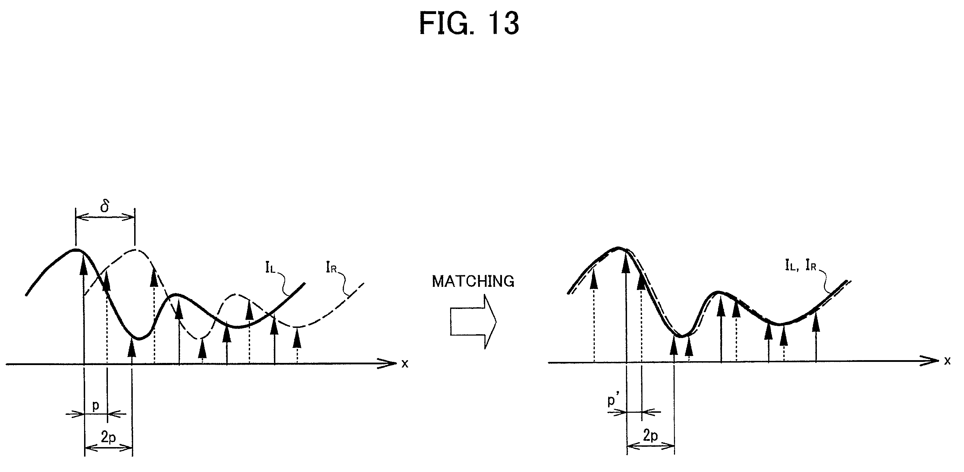

According to a known phase difference detection process, the phase difference detection resolution is determined by the density of the sampling pixels that correspond to each parallax image (i.e., each of two parallax images) captured using the pupil division technique. Specifically, the waveform pattern of each parallax image is handled as data sampled corresponding to each sampling pixel (see the left side in FIG. 13). When calculating the correlation coefficient while shifting the relative position of two waveform patterns from the initial position, the correlation coefficient is obtained at a relative position at which the sampling positions of the two waveform patterns coincide with each other. Therefore, the matching position detection resolution is determined by the sampling density, and the resolution of the phase difference that is the difference between the initial position and the matching position is also determined by the sampling density.

For example, a case where the phase difference detection process is applied to a ranging process is discussed below. The range resolution $\Delta z$ is determined by the phase difference detection resolution $\Delta s$ (as described later with reference to the expression (15)). Specifically, it is necessary to increase the phase difference detection resolution in order to implement a high-resolution ranging process. However, the pixel density of an image sensor has approached the upper limit of the optical resolution, and it is not considered that a significant improvement in pixel density will be achieved in the future. Therefore, it is a great challenge to implement high-density sampling at a sampling density equal to or higher than the pixel density of an image sensor.

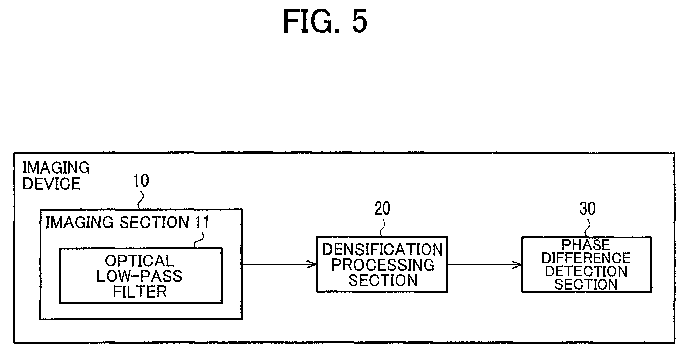

FIG. 5 illustrates a configuration example of an imaging device according to the second embodiment that can solve the above problem. The imaging device includes an imaging section 10 that includes an optical low-pass filter 11, a densification processing section 20, and a phase difference detection section 30.

The densification processing section 20 performs a densification process that increases the number of pixels of the first image and the second image to virtually decrease the sampling pitch of the first object image and the second object image. The phase difference detection section 30 detects the phase difference between the first image and the second image that have been subjected to the densification process.

For example, a monocular imaging optical system is subjected to pupil division, and parallax images are acquired using an image sensor having a Bayer array (see the third embodiment described later). The first object image that has passed through the first pupil is captured using the red pixels, and the second object image that has passed through the second pupil is captured using the blue pixels. The first image and the second image that have a sampling density (pixel pitch p/N) that is higher than the pixel density (pixel pitch p) of the image sensor by a factor of N are thus generated.

According to this configuration, it is possible to generate parallax images of which the apparent sampling density is significantly higher than the pixel density of the image sensor. It is possible to implement a phase difference detection process with a significantly improved detection resolution by detecting the phase difference using the resulting parallax images. According to the above example, since the correlation coefficient can be calculated at an N-fold density, it is possible to detect the phase difference at an N-fold resolution.

## 4. Third embodiment

### 4.1. Stereo image measurement method

The details of the densification process are described below in connection with a third embodiment of the invention. In the third embodiment, a monocular imaging section is subjected to pupil division, and different colors are respectively assigned to the two pupils to acquire parallax images, which are subjected to the densification process.

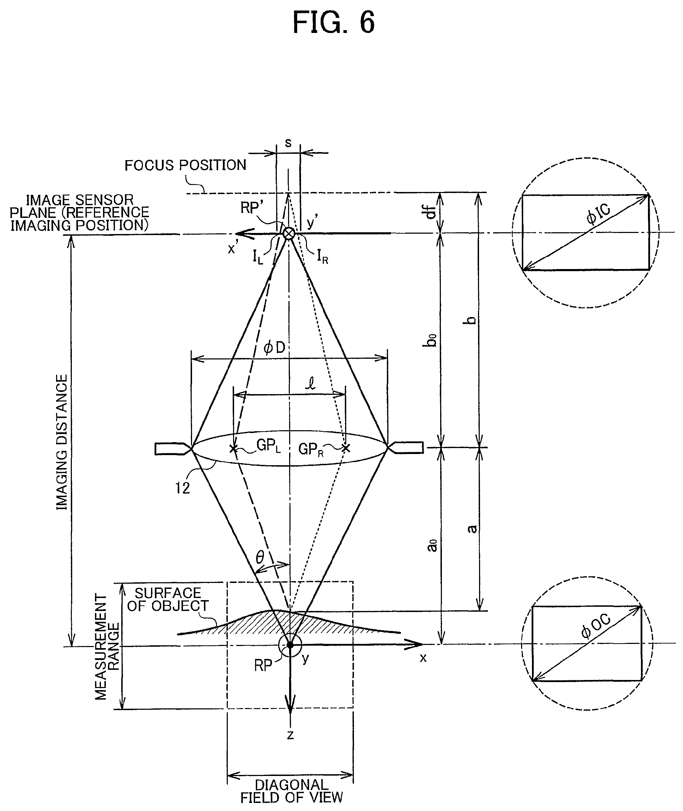

The basic principle of the stereo image measurement method that utilizes the pupil division technique is described below with reference to FIG. 6. Although an example in which the pupil is divided in the rightward-leftward direction (horizontal scan direction) is described below, the pupil need not necessarily be divided in the rightward-leftward direction. It suffices that the pupil be divided in an arbitrary direction that is orthogonal to the optical axis.

Reflected light from the surface of the object passes through an imaging lens 12 (imaging optical system), forms an image in the image sensor plane, and is acquired by the image sensor as an image signal. The coordinate axes when a reference position RP of the object is set to be the origin are referred to as (x, y, z), and the coordinate axes when an in-focus position RP' in the image sensor plane is set to be the origin are referred to as (x', y'). For example, the x'-axis corresponds to the horizontal scan direction of the image sensor, and the y'-axis corresponds to the vertical scan direction of the image sensor. The z-axis corresponds to the direction along the optical axis of the imaging lens 12 (i.e., depth distance direction).

The distance from the reference position RP of the object to the center of the imaging lens 12 is referred to as $a_0$, and the distance from the center of the imaging lens 12 to the image sensor plane is referred to as $b_0$. The distance $a_0$ and the distance $b_0$ are determined by the design of the imaging section.

The left half of the imaging lens 12 is referred to as a left pupil, and the right half of the imaging lens 12 is referred to as a right pupil. $GP_L$ is the center-of-gravity position (center of gravity) of the left pupil, and $GP_R$ is the center-of-gravity position (center of gravity) of the right pupil. An image obtained in the image sensor plane is defocused as the surface of the object moves away from the reference position in the z-direction, and an image $I_L$ that has passed through the left pupil and an image $I_R$ that has passed through the right pupil (hereinafter referred to as "left-pupil image" and "right-pupil image", respectively) are shifted from each other (i.e., have a phase difference s). Although FIG. 6 illustrates an example in which the pupil position is situated at the center of the lens for convenience of explanation, the pupil position is present at a position (e.g., aperture) outside the lens in the actual situation.

The relationship between the phase difference s and the position z of the surface of the object is calculated. The relationship between the phase difference s between the left-pupil image $I_L$ and the right-pupil image $I_R$ obtained in the image sensor plane and the position z of the surface of the object is determined by the following expression (14).

$$s = \frac{-Ml \cdot z}{z + a_0} \qquad (14)$$

Note that M is the total optical magnification at a reference in-focus position. When the imaging field-of-view circle diameter is $\varphi IC$, and the field-of-view circle diameter in the imaging range is $\varphi OC$, $M=\varphi IC/\varphi OC=b_0/a_0$. 1 is the distance between the center of gravity $GP_L$ of the left pupil and the center of gravity $GP_R$ of the right pupil. Note that the expression (14) is satisfied with respect to the axis of the optical system. A relational expression with respect to the outside of the axis is omitted for convenience of explanation.

It is necessary to separately acquire the left-pupil image $I_L$ and the right-pupil image $I_R$ in order to calculate the phase difference s. The left-pupil image $I_L$ and the right-pupil image $I_R$ may be separately acquired (separated) in various ways. For example, a red-pass optical filter is provided at the left pupil position, and a blue-pass optical filter is provided at the right pupil position. A red image obtained by the image sensor is separated as the left-pupil image, and a blue image obtained by the image sensor is separated as the right-pupil image. Alternatively, the left-pupil image and the right-pupil image are separately acquired using the angle of light that enters the image sensor plane (see JP-A-2009-145401). Alternatively, parallax stereo images that correspond to the left-pupil image and the right-pupil image are separately acquired using a binocular camera. These methods may be selectively used corresponding to the intended use (objective) and the application.

It is important to increase the z resolution in order to implement an accurate 3D measurement process. The following expression (15) is obtained by transforming the expression (14) so that the z resolution $\Delta z$ is represented using the phase difference resolution $\Delta s$.

$$\Delta z = \frac{-\Delta s}{Ml + \Delta s} \qquad (15)$$

As is clear from the expression (15), it is necessary to decrease the z resolution $\Delta z$ by decreasing the phase difference resolution $\Delta s$ in order to improve the measurement resolution in the z-direction. Specifically, it is necessary to more finely detect the phase difference between the left-pupil image and the right-pupil image in order to increase the z resolution $\Delta z$. It is necessary to increase the sampling density of the left-pupil image and the right-pupil image using the image sensor in order to more finely detect the phase difference between the left-pupil image and the right-pupil image. However, the sampling density is limited by the pixel pitch of an image sensor, and the pixel pitch of an image sensor has approached the limit. It is difficult to further reduce the pixel pitch of an image sensor.

4.2. Imaging device

FIG. 7 illustrates a configuration example of an imaging device according to the third embodiment. The imaging device includes an imaging section 10, a densification processing section 20 (densification measurement development section), a phase difference detection section 30, an optical characteristic storage section 40, a ranging calculation section 80, and a three-dimensional shape output processing section 90. Note that the same elements as those described above are indicated by the same reference signs (symbols), and description thereof is appropriately omitted.

The imaging section 10 includes an optical low-pass filter 11, an imaging lens 12 (imaging optical system), a pupil division filter 13, an image sensor 14, and an imaging processing section 15.

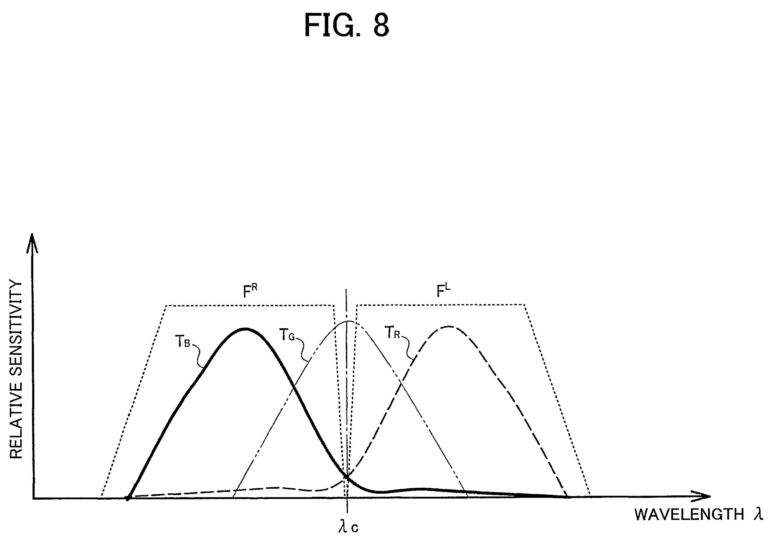

An R (red) filter is provided to the pupil division filter 13 corresponding to the left pupil, and a B (blue) filter is provided to the pupil division filter 13 corresponding to the right pupil. The image sensor 14 is an RGB color image sensor having a Bayer pixel array. FIG. 8 illustrates the spectral characteristics of the pupil division filter 13 and the image sensor 14. $F^L$ indicates the spectral characteristics of the left-pupil filter (R filter), and $F^R$ indicates the spectral characteristics of the right-pupil filter (B filter). $T_B$, $T_G$, and $T_R$ indicate the spectral characteristics of the B pixel, the G (green) pixel, and the R pixel, respectively. The pupil spectral characteristics $F^L$ and $F^R$ are divided at the cross point (wavelength $\lambda c$) of the spectral characteristics $T_B$ of the B pixel and the spectral characteristics $T_R$ of the R pixel, and cover the entire RGB band. The spectral characteristics $F^L$ and $F^R$ are designed to allow the G component (part of the G component) to pass through.

Note that the spectral characteristics $\{T_B, T_G, T_R\}$ are defined as composite spectral characteristics of the characteristics of the color filters provided to the image sensor 14 on a pixel basis, the spectral characteristics of external light or illumination light applied to the object, and the spectral characteristics of each pixel. The parameters regarding the spectral characteristics are setting values (corresponding values) with respect to the wavelength $\lambda$. Note that the notation of the wavelength $\lambda$ used as a dependent variable is omitted.

Reflected light from the object passes through the imaging lens 12, the pupil division filter 13, and the optical low-pass filter 11, and forms an image on the image sensor 14. In this case, a component value calculated by multiplying the spectral characteristics of the reflected light from the object by the left-pupil spectral characteristics $F^L$ and the spectral characteristics $T_R$ of the R pixel is obtained as the pixel value of the R pixel. Likewise, a component value calculated by multiplying the spectral characteristics of the reflected light from the object by the right-pupil spectral characteristics $F^R$ and the spectral characteristics $T_B$ of the B pixel is obtained as the pixel value of the B pixel. Specifically, the left-pupil image is obtained by the R image included in the Bayer image, and the right-pupil image is obtained by the B image included in the Bayer image.

The imaging processing section 15 controls the imaging operation, and processes an imaging signal. For example, the imaging processing section 15 converts the pixel signal from the image sensor 14 into digital data, and outputs Bayer-array image data (RAW image data).

The densification processing section 20 performs the sampling density densification process for detecting the phase difference between the R image and the B image at a resolution smaller (lower) than the sampling pixel pitch. The densification process increases the sampling density by a factor of $N \times N$. Note that N is 100 to 10,000, for example. The details of the densification process are described later.

Note that the densification processing section 20 may perform a high-accuracy separation process on the R image and the B image based on the spectral characteristics $F^R$, $F^L$, $T_B$, $T_G$, and $T_R$ stored in the optical characteristic storage section 40. For example, the spectral characteristics $T_B$ of the R pixel also have a component within the band of the left-pupil spectral characteristics $F^L$. Therefore, the R image (right-pupil image) includes the left-pupil component mixed therein. The densification processing section 20 may perform a process that reduces such a right pupil-left pupil mixed state based on the spectral characteristics $F^R$, $F^L$, $T_B$, $T_G$, and $T_R$.

The phase difference detection section 30 includes a phase difference rough detection section 50, a detectable area extraction section 60 (detectable feature part extraction section), and a phase difference fine detection section 70.

The phase difference rough detection section 50 performs the phase difference detection process that is lower in density than the phase difference detection process performed by the phase difference fine detection section 70. For example, the phase difference rough detection section 50 performs a correlation calculation process on the image that has been subjected to the densification process or the Bayer image that has not been subjected to the densification process in a state in which the pixels are thinned out.

The detectable area extraction section 60 determines whether or not a phase difference can be detected based on the correlation coefficient from the phase difference rough detection section 50, determines whether or not the distance information in the z-direction can be acquired based on the determination result, and outputs an image of the detectable area to the phase difference fine detection section 70. For example, the detectable area extraction section 60 determines whether or not a phase difference can be detected by determining whether or not a correlation peak is present.

The phase difference fine detection section 70 performs the phase difference detection process on the image that has been subjected to the densification process to finely detect the phase difference at a resolution smaller than the sampling pixel pitch. The phase difference fine detection section 70 performs the phase difference detection process on the area for which it has been determined by the detectable area extraction section 60 that a phase difference can be detected.

The ranging calculation section 80 calculates the distance in the z-direction at a high resolution based on the phase difference detected by the phase difference fine detection section 70. The three-dimensional shape output processing section 90 generates three-dimensional shape data based on the distance information in the z-direction, and outputs the generated three-dimensional shape data.

4.3. Densification process

The sampling density densification process is described in detail below.

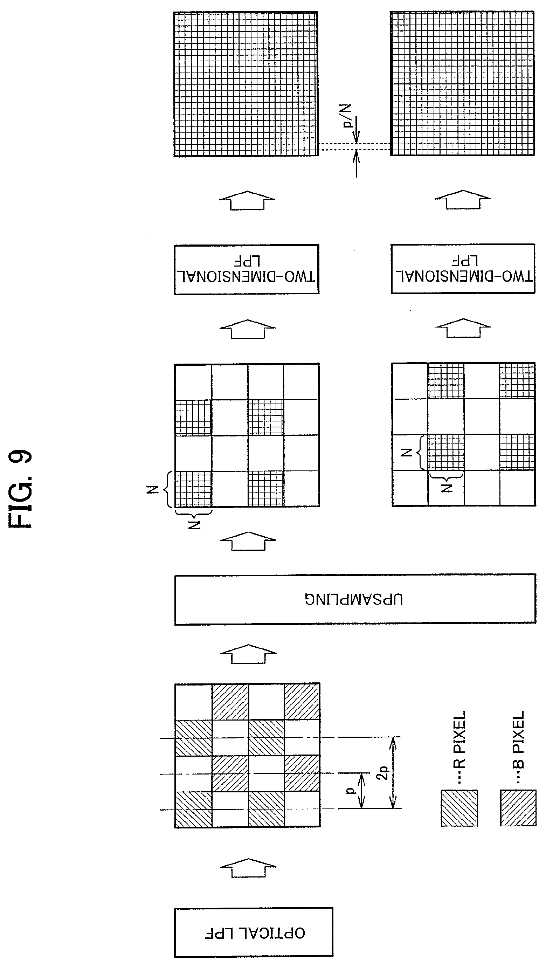

The right-pupil image and the left-pupil image (R pupil image and B pupil image) that have passed through the optical low-pass filter 11 are sampled by the color image sensor 14. The R pixels and the B pixels are arranged in the image sensor 14 as illustrated in FIG. 9. The optical low-pass filter 11 is an anti-aliasing filter, and is provided so that folding noise does not occur in the R pupil image and the B pupil image. Since the sampling pitch of each pupil image is 2p, the sampling frequency is 1/(2p), and the cut-off frequency is set to be equal to or lower than the Nyquist frequency (1/(4p)) determined corresponding to the sampling frequency.

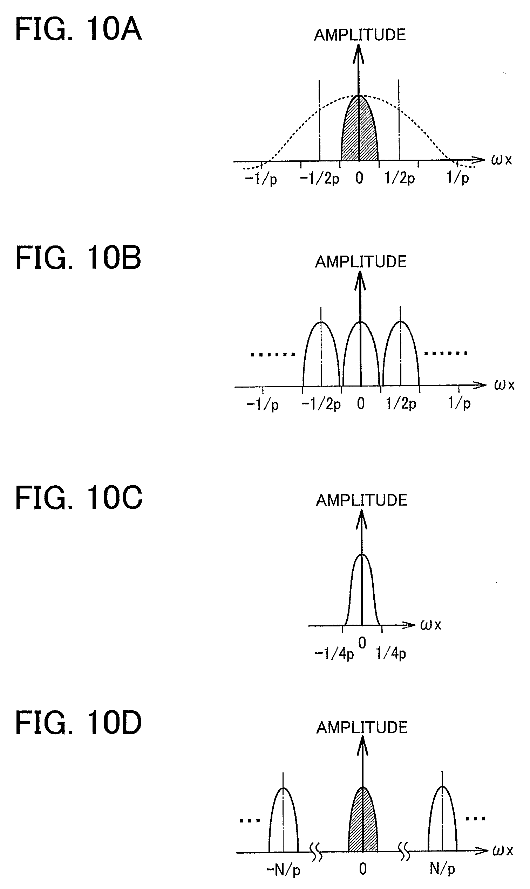

FIG. 10A illustrates the frequency characteristics of the R image and the B image. Specifically, when the frequency characteristics of the optical LPF are represented by 1/(4p), for example, the R image and the B image have a band within the range from -1/(4p) to +1/(4p). The repetition cycle is 1/(2p) (not illustrated in the drawings). Note that the dotted line represents the frequency characteristics of the pixel aperture. The pixel aperture has a band within the range from -1/p to +1/p corresponding to the aperture width p.

Next, data is generated so that each sampling pixel of the R pupil image and the B pupil image obtained by the image sensor 14 includes micro-pixels (apparent pixels) that have a size equal to or smaller than that of one pixel. For example, when generating the pixel values sampled using pixels having a size 1/10th of that of one pixel in the vertical direction and the horizontal direction, one pixel is equally divided into ten areas (N=10) in the vertical direction and the horizontal direction so that one pixel includes one hundred (N×N=100) micro-pixels. The pixel value of the original pixel is used as the pixel value of each micro-pixel. The above upsampling process is performed on each R pixel and each B pixel.

FIG. 10B illustrates the frequency characteristics of the resulting R image and the resulting B image. Since each pixel is merely divided, and the data is merely duplicated, the frequency characteristics are the same as those before the upsampling process is performed. Specifically, the R image and the B image have a band within the range from -1/(4p) to +1/(4p), and the repetition cycle is 1/(2p), for example.

The sampling data formed by the micro-pixels is filtered using a two-dimensional low-pass filter, and the micro-pixels (including pixels in an undetected area) over the entire captured image are reconstructed. Specifically, image data having a pixel pitch of p/N (p=pixel pitch of image sensor 14) is generated to obtain an N-fold sampling density (apparent sampling density). The cut-off frequency of the two-dimensional low-pass filter is set to be equal to or lower than the Nyquist frequency (1/(4p)) that is determined by the R or B sampling pitch 2p in the same manner as the optical low-pass filter. The two-dimensional low-pass filter is a Gaussian filter, for example.

The two-dimensional low-pass filter has the frequency characteristics illustrated in FIG. 10C, for example. The R image and the B image that have been subjected to the two-dimensional low-pass filtering process have the frequency characteristics illustrated in FIG. 10D, for example. The repetition frequency changes to N/p since the pixel pitch has changed to p/N. The band of the R image and the B image corresponds to a band calculated by multiplying the frequency characteristics of the optical low-pass filter by the frequency characteristics of the two-dimensional low-pass filter.

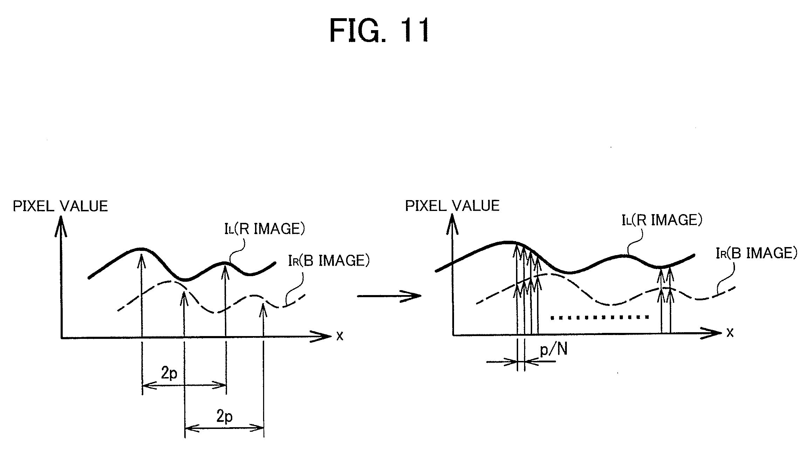

The left-pupil image (R pupil image) $I_L$ and the right-pupil image (B pupil image) $I_R$ before being subjected to the densification process are images sampled at a pitch of 2p (see the left side in FIG. 11). The left-pupil image (R pupil image) $I_L$ and the right-pupil image (B pupil image) $I_R$ that have been subjected to the densification process are obtained as image data sampled at a density (pitch: p/N) that is significantly higher than the sampling density of the image sensor 14 (see the right side in FIG. 11).

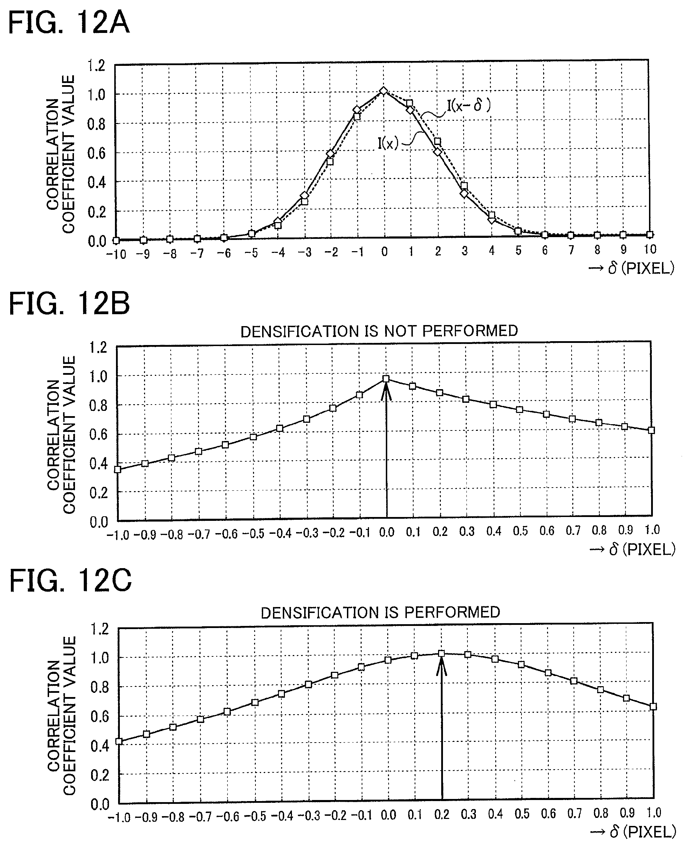

FIGS. 12A to 12C illustrate the simulation results for the phase difference detection process using the densification process. The horizontal axis indicates the shift amount (pixels) from the initial position "0" used for the correlation calculation process.

FIG. 12A illustrates a waveform for calculating the phase difference. When the pixel pitch of the image sensor is p, the waveform I(x) and the waveform I(x-δ) have a phase difference δ of 0.2 p (waveforms sampled at a pixel pitch of p).

FIG. 12B illustrates the simulation results when the sampling waveform I(x) and the sampling waveform I(x-δ) are merely upsampled (0.1p) (i.e., one pixel is divided on a 0.1p basis, and the pixel value of the pixel is duplicated), and the cross-correlation coefficient is calculated (shift: 0.1p). The correlation peak should be detected at δ=0.2p. However, since the sampling waveform has only a value on a pixel basis, the correlation peak is observed at δ=0 (i.e., detection at a resolution equal to or lower than one pixel is not achieved).

FIG. 12C illustrates the simulation results when the densification process according to the third embodiment is performed on the sampling waveform I(x) and the sampling waveform I(x-δ), and the cross-correlation coefficient is calculated. Specifically, FIG. 12C illustrates the simulation results when the low-pass filter having a cut-off frequency equal to or lower than 1/(4p) is applied after the upsampling process, and the cross-correlation coefficient is calculated (shift: 0. 1p). A clear correlation peak is observed at δ=0.2p (i.e., a resolution of 0.1p is achieved).

Specifically, it is possible to achieve a phase difference detection resolution equal to or smaller than the pixel pitch of the image sensor by performing the upsampling process and the two-dimensional low-pass filtering process according to the third embodiment.

When using a normal phase difference detection process, the similarity between the left-pupil image (R pupil image) sampling data and the right-pupil image (B pupil image) sampling data deteriorates due to the difference in sampling position. The method according to the third embodiment can solve this problem. This feature is described below with reference to FIG. 13.

As illustrated in FIG. 13 (see the left side), the left-pupil image (R pupil image) $I_L$ and the right-pupil image (B pupil image) $I_R$ have an approximately identical waveform, and have a phase difference δ. The right side in FIG. 13 illustrates a state in which the waveform of the pupil image $I_L$ and the waveform of the pupil image $I_R$ are caused to overlap each other. In this case, the pupil image $I_L$ and the pupil image $I_R$ are matched, and it is desirable that the correlation coefficient at a position at which the waveforms have the highest similarity be obtained.

However, since the parallax δ is arbitrary, the R pixel sampling position and the B pixel sampling position normally differ from each other with respect to the pupil image $I_L$ and the pupil image $I_R$ that have an approximately identical waveform. Therefore, even when the left-pupil image (R pupil image) $I_L$ and the right-pupil image (B pupil image) $I_R$ are optically identical, different sampling data is obtained (i.e., the similarity is lost), for example. This means that it is impossible to calculate the correct position when calculating the matching position of the pupil image $I_L$ and the pupil image $I_R$ from the correlation coefficient.

For example, when the correlation coefficient is calculated while shifting the pupil image $I_L$ and the pupil image $I_R$ by one sampling pixel (i.e., at a pitch of 2p), the correlation coefficient is obtained at each position at which the pixel of the pupil image $I_L$ and the pixel of the pupil image $I_R$ (i.e., solid arrow and dotted arrow) coincide with each other. Specifically, the correlation coefficient when the waveforms coincide with each other is not obtained when the pupil image $I_L$ and the pupil image $I_R$ differ in sampling position, and a phase difference detection error occurs.

According to the third embodiment, since the high-density sampling data of the pupil image $I_L$ and the pupil image $I_R$ can be obtained (see the right side in FIG. 11), it is possible to ensure that the sampling data have similarity, and improve the phase difference detection accuracy. Moreover, since the noise component superimposed on the R pupil image $I_L$ and the B pupil image $I_R$ is reduced by applying the two-dimensional low-pass filtering process, it is possible to suppress or reduce a variation in matching position detection error due to noise.

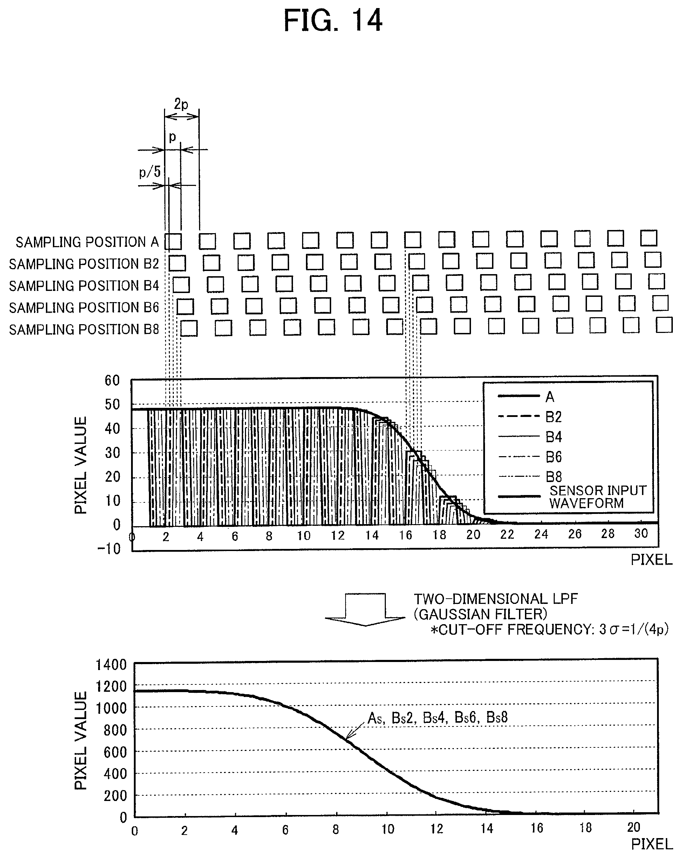

FIG. 14 illustrates the sampling data similarity simulation results. The upper part in FIG. 14 illustrates the sampling position. The sampling positions B2, B4, B6, and B8 are positions that are sequentially shifted from the sampling position A by 0.2p. For example, when the phase difference is 0.6p, the left-pupil image is sampled at the sampling position A, and the right-pupil image is sampled at the sampling position B6.

The middle part in FIG. 14 illustrates the sampling data. The sampling data represents data obtained by sampling the sensor input waveform at the sampling positions A, B2, B4, B6, and B8. The sensor input waveform is the waveform of the object image formed in the sensor plane. In this case, the similarity between the sampling data is low due to the difference in sampling position.

The lower part in FIG. 14 illustrates the results obtained by subjecting the sampling data to the densification process according to the third embodiment. The waveform data As, Bs2, Bs4, Bs6, and Bs8 correspond to the sampling positions A, B2, B4, B6, and B8. The waveform data As, Bs2, Bs4, Bs6, and Bs8 coincide with each other, and cannot be distinguished from each other (i.e., the similarity between the sampling data is high). It is possible to implement a highly accurate phase difference detection process by utilizing the sampling data having high similarity.

According to the third embodiment, the imaging section 10 includes the optical low-pass filter 11 that has a cut-off frequency equal to or lower than 1/(2P) when the pitch of the pixels used to capture the first object image and the pitch of the pixels used to capture the second object image are P. The densification processing section 20 performs the densification process that includes performing the upsampling process on the first image $I_L$ (left-pupil image, R image) and the second image $I_R$ (right-pupil image, B image), and performing the two-dimensional low-pass filtering process on the first image $I_L$ and the second image $I_R$ that have been subjected to the upsampling process.

In the third embodiment, the sampling pitch of the first image $I_L$ and the sampling pitch of the second image $I_R$ are P=2p (see FIG. 9). The upsampling process is performed on the first image $I_L$ and the second image $I_R$ to increase the number of pixels of the first image $I_L$ and the number of pixels of the second image $I_R$ by a factor of N×N, and the two-dimensional low-pass filtering process is performed on the first image $I_L$ and the second image $I_R$.

This makes it possible to obtain parallax images having an apparent sampling density (pixel pitch p/N) that is higher than the pixel density (pixel pitch p) of the image sensor by a factor of N. It is possible to implement a phase difference detection process with a significantly improved detection resolution by detecting the phase difference using the resulting parallax images (as described above with reference to FIG. 12 and the like).

It is possible to implement a more accurate phase difference detection process by applying the improved SAD (see above). Specifically, since a high-frequency component is cut by the two-dimensional LPF during the densification process, the phase difference detection process may be affected by noise since the phase difference between the waveforms of the low-frequency components are detected. However, since the effects of noise can be reduced by applying the improved SAD, it is possible to maximize the detection resolution achieved by the densification process.

When the third embodiment is applied to a binocular imaging section, image sensors are respectively provided to binocular imaging optical systems, for example. In this case, the sampling pitch P of each parallax image is the same as the pixel pitch p of the image sensor (i.e., P=p).

According to the third embodiment, the imaging section 10 includes the imaging optical system (imaging lens 12), the pupil division filter 13 that divides the pupil of the imaging optical system into a first pupil (left pupil) that allows the first object image to pass through, and a second pupil (right pupil) that allows the second object image to pass through, and the image sensor 14 that captures the first object image and the second object image formed by the imaging optical system.

According to this configuration, it is possible to capture parallax images using the monocular imaging section 10. It is possible to implement a high-resolution ranging process using a monocular system by subjecting the parallax images to the densification process. Specifically, it is necessary to increase the pupil-to-pupil center-of-gravity distance 1 in order to increase the resolution Δz of the ranging process (see the expression (15)). However, it is difficult to increase the pupil-to-pupil center-of-gravity distance 1 when using a monocular system as compared with the case of using a binocular system. According to the third embodiment, however, since the phase difference detection resolution $\Delta s$ can be increased by utilizing the densification process, it is possible to implement a high-resolution ranging process even when the pupil-to-pupil center-of-gravity distance 1 is short (see the expression (15)). For example, a reduction in the diameter of a scope is desired for an endoscope (e.g., industrial endoscope and medical endoscope). It is possible to easily implement a reduction in the diameter of a scope when using a monocular system, and it is possible to implement a highly accurate ranging process by utilizing the densification process even when the pupil-to-pupil center-of-gravity distance 1 has decreased due to a reduction in the diameter of the scope.

According to the third embodiment, the image sensor 14 is an image sensor having a primary-color Bayer array. The pupil division filter 13 includes a filter that corresponds to the first pupil and allows light within a wavelength band that corresponds to red to pass through (spectral characteristics $F^L$ illustrated in FIG. 8), and a filter that corresponds to the second pupil and allows light within a wavelength band that corresponds to blue to pass through (spectral characteristics $F^R$ illustrated in FIG. 8). The densification processing section 20 performs the densification process on a red image and a blue image included in a Bayer-array image captured by the image sensor 14, the red image corresponding to the first image (left-pupil image), and the blue image corresponding to the second image (right-pupil image).

This makes it possible to implement a high-resolution phase difference detection process using a color image sensor having a primary-color Bayer array that is widely used. Since the parallax images can be formed by merely inserting the pupil division filter 13, and extracting the R image and the B image, it is possible to implement a high-resolution phase difference detection process without changing a known imaging section to a large extent. Since only the pupil division filter 13 is additionally provided to the optical system, it is possible to use the imaging section 10 having a compact configuration, and implement an endoscope having a small diameter (see above), for example.

According to the third embodiment, when the pixel pitch of the image sensor 14 is referred to as p, the pitch of the red pixels used to capture the first object image and the pitch of the blue pixels used to capture the second object image are P=2p. The cut-off frequency of the optical low-pass filter 11 is equal to or lower than $1/(2P)=1/(4p)$.

When implementing a normal capture operation without using the pupil division technique, the Nyquist frequency that corresponds to the pixel pitch p of the image sensor is $1/(2p)$, and the cut-off frequency of the optical low-pass filter 11 is set to be equal to or lower than $1/(2p)$. According to the third embodiment, since the sampling process is performed on each parallax image, the cut-off frequency of the optical low-pass filter 11 is set to be equal to or lower than the Nyquist frequency $1/(4p)$ that corresponds to the sampling pitch 2p. This makes it possible to suppress or reduce the occurrence of folding noise in the parallax images.

According to the third embodiment, the densification processing section 20 performs the upsampling process that divides each pixel of the first image and the second image into N×N pixels, and duplicates the pixel value of the original pixel to the N×N pixels.

According to the third embodiment, the cut-off frequency of the two-dimensional low-pass filtering process is equal to or lower than $1/(2P)$.

It is possible to provide data that includes micro-pixels by dividing each pixel of the parallax images into N×N pixels, and duplicating the pixel value of the original pixel. It is possible to generate the parallax images (as if the sampling process were performed using the micro-pixels) by subjecting the data to the two-dimensional low-pass filtering process using a cut-off frequency equal to or lower than $1/(2P)$. Since the frequency band of the parallax image is limited to be equal to or lower than $1/(2P)$ due to the optical low-pass filter 11, it is possible to reduce noise outside the band while allowing the component of the parallax image to remain by setting the cut-off frequency of the two-dimensional low-pass filter to be equal to or lower than $1/(2P)$.

Although an example that utilizes a color image sensor having a primary-color Bayer array has been described above, the configuration is not limited thereto. For example, a complementary-color image sensor may also be used. In this case, an R image and a B image are generated from a YCrCb image captured by the complementary-color image sensor, and used as the parallax images.

The embodiments to which the invention is applied and the modifications thereof have been described above. Note that the invention is not limited to the above embodiments and the modifications thereof. Various modifications and variations may be made without departing from the scope of the invention. A plurality of elements described in connection with the above embodiments and the modifications thereof may be appropriately combined to implement various configurations. For example, some elements may be omitted from the elements described in connection with the above embodiments and the modifications thereof. The elements described above in connection with different embodiments or modifications thereof may be appropriately combined. Specifically, various modifications and applications are possible without materially departing from the novel teachings and advantages of the invention. Any term cited with a different term having a broader meaning or the same meaning at least once in the specification and the drawings can be replaced by the different term in any place in the specification and the drawings.

REFERENCE SIGNS LIST

10: imaging section, 11: optical low-pass filter, 12: imaging lens, 13: pupil division filter, 14: image sensor, 15: imaging processing section, 20: densification processing section, 30: phase difference detection section, 40: optical characteristic storage section, 50: phase difference rough detection section, 60: detectable area extraction section, 70: phase difference fine detection section, 80: ranging calculation section, 90: three-dimensional shape output processing section, $F^L$, $F^R$: spectral characteristics, Fa: fall interval, $I_L$: left-pupil image, $I_R$: right-pupil image, P: sampling pitch, Ra: rise interval, $T_B$, $T_G$, $T_R$: spectral characteristics, nI: composite waveform, $nI_L$: normalized left-pupil image, $nI_R$: normalized right-pupil image, p: pixel pitch, s: phase difference, w: given calculation interval, x, y, z, x', y': coordinate, $\Delta s$: phase difference resolution, $\Delta z$: range resolution, $\delta$: phase difference, $\sigma$: variance

**Claims**

1.  An imaging device comprising:

    an imaging section that captures a first object image and a second object image that have parallax with respect to an identical object; and
    a phase difference detection section that calculates a correlation coefficient between a first image in which the first object image is captured, and a second image in which the second object image is captured, and detects a phase difference between the first image and the second image based on the correlation coefficient,

    wherein the phase difference detection section subjects a pixel value of the first image and a pixel value of the second image to a normalization process, calculates an average value of the pixel value of the first image and the pixel value of the second image that have been subjected to the normalization process, and calculates the correlation coefficient based on a value obtained by adding up values obtained by subjecting the pixel value of the first image and the pixel value of the second image that have been subjected to the normalization process to a subtraction process within a fall interval in which the average value decreases, and a value obtained by adding up values obtained by subjecting the pixel value of the first image and the pixel value of the second image that have been subjected to the normalization process to the subtraction process within a rise interval in which the average value increases.

2.  The imaging device as defined in claim 1,
    wherein the phase difference detection section calculates intersections of the pixel value of the first image and the pixel value of the second image that have been subjected to the normalization process within a given interval along an epipolar line of the first image and the second image to determine a plurality of intervals that are included within the given interval and defined by the intersections, sets an interval among the plurality of intervals in which the average value increases to be the rise interval, and sets an interval among the plurality of intervals in which the average value decreases to be the fall interval.

3.  The imaging device as defined in claim 1 or 2,
    wherein the phase difference detection section determines a magnitude relationship between the pixel value of the first image and the pixel value of the second image that have been subjected to the normalization process corresponding to each of the fall interval and the rise interval, subjects the pixel value of the first image and the pixel value of the second image that have been subjected to the normalization process to the subtraction process corresponding to each of the fall interval and the rise interval based on the determined magnitude relationship so that the values obtained by the subtraction process are positive values, and adds up the values obtained by the subtraction process to calculate the correlation coefficient.

4.  The imaging device as defined in claim 1 or 2,
    wherein the phase difference detection section calculates the correlation coefficient by adding up an absolute value of the value obtained by adding up the values obtained by subjecting the pixel value of the first image and the pixel value of the second image that have been subjected to the normalization process to the subtraction process within the fall interval, and an absolute value of the value obtained by adding up the values obtained by subjecting the pixel value of the first image and the pixel value of the second image that have been subjected to the normalization process to the subtraction process within the rise interval.

5.  The imaging device as defined in any one of claims 1 to 4, further comprising:

a densification processing section that performs a densification process that increases a number of pixels of the first image and the second image to virtually decrease a sampling pitch of the first object image and the second object image,

wherein the phase difference detection section detects the phase difference between the first image and the second image that have been subjected to the densification process.

6. The imaging device as defined in claim 5,
wherein the imaging section includes an optical low-pass filter that has a cut-off frequency equal to or lower than $1/(2P)$ when a pitch of pixels used to capture the first object image and a pitch of pixels used to capture the second object image are P, and

the densification processing section performs the densification process that includes performing an upsampling process on the first image and the second image, and performing a two-dimensional low-pass filtering process on the first image and the second image that have been subjected to the upsampling process.

7. The imaging device as defined in claim 5 or 6,
wherein the imaging section includes:

an imaging optical system;
a pupil division filter that divides a pupil of the imaging optical system into a first pupil that allows the first object image to pass through, and a second pupil that allows the second object image to pass through; and
an image sensor that captures the first object image and the second object image formed by the imaging optical system.

8. The imaging device as defined in claim 7,
wherein the image sensor is an image sensor having a primary-color Bayer array,
the pupil division filter includes a filter that corresponds to the first pupil and allows light within a wavelength band that corresponds to red to pass through, and a filter that corresponds to the second pupil and allows light within a wavelength band that corresponds to blue to pass through, and
the densification processing section performs the densification process on a red image and a blue image included in a Bayer-array image captured by the image sensor, the red image corresponding to the first image, and the blue image corresponding to the second image.

9. The imaging device as defined in claim 6,
wherein the densification processing section performs the upsampling process that divides each pixel of the first image and the second image into N×N pixels, and duplicates a pixel value of an original pixel to the N×N pixels.

10. The imaging device as defined in claim 6,
wherein a cut-off frequency of the two-dimensional low-pass filtering process is equal to or lower than $1/(2P)$.

11. A phase difference detection method comprising:

capturing a first object image and a second object image that have parallax with respect to an identical object;
subjecting a pixel value of a first image and a pixel value of a second image to a normalization process, the first image being an image in which the first object image is captured, and the second image being an image in which the second object image is captured;
calculating an average value of the pixel value of the first image and the pixel value of the second image that have been subjected to the normalization process;
calculating a correlation coefficient based on a value obtained by adding up values obtained by subjecting the pixel value of the first image and the pixel value of the second image that have been subjected to the normalization process to a subtraction process within a fall interval in which the average value decreases, and a value obtained by adding up values obtained by subjecting the pixel value of the first image and the pixel value of the second image that have been subjected to the normalization process to the subtraction process within a rise interval in which the average value increases; and
detecting a phase difference between the first image and the second image based on the correlation coefficient.

FIG. 1

# FIG. 2

IMAGING DEVICE

10

IMAGING
SECTION

30

PHASE
DIFFERENCE
DETECTION
SECTION

# FIG. 3

PIXEL VALUE

$I_L$

$I_R$

W

NORMALIZATION

PIXEL VALUE

$\delta$

nI

$nI_R$

$nI_L$

Fa | Ra | Fa

FALL   RISE FALL

# FIG. 4

# FIG. 5

IMAGING DEVICE 10

IMAGING SECTION 11

OPTICAL LOW-PASS FILTER

20

DENSIFICATION PROCESSING SECTION

30

PHASE DIFFERENCE DETECTION SECTION

# FIG. 6

FOCUS POSITION

s

IMAGE SENSOR
PLANE (REFERENCE
IMAGING POSITION)

df

$\phi$IC

RP'

y'

$I_L$  $I_R$

x'

b

$b_0$

$\phi$D

$\ell$

IMAGING DISTANCE

$GP_L$  $GP_R$

12

$\theta$

a

$a_0$

SURFACE
OF OBJECT

MEASUREMENT
RANGE

$\phi$OC

RP  y

x

z

DIAGONAL
FIELD OF VIEW

FIG. 7

# FIG. 8

FIG. 9

FIG. 10A

AMPLITUDE

$-1/p$  $-1/2p$  $0$  $1/2p$  $1/p$  $\omega x$

FIG. 10B

AMPLITUDE

$-1/p$  $-1/2p$  $0$  $1/2p$  $1/p$  $\omega x$

FIG. 10C

AMPLITUDE

$-1/4p$  $0$  $1/4p$  $\omega x$

FIG. 10D

AMPLITUDE

$-N/p$  $0$  $N/p$  $\omega x$

# FIG. 11

EP 3 062 065 A1

PIXEL VALUE

$I_L$(R IMAGE)

$I_R$(B IMAGE)

X

2p

2p

PIXEL VALUE

$I_L$(R IMAGE)

$I_R$(B IMAGE)

X

p/N

## FIG. 12A

## FIG. 12B

DENSIFICATION IS NOT PERFORMED

## FIG. 12C

DENSIFICATION IS PERFORMED

# FIG. 13

# FIG. 14

SAMPLING POSITION A
SAMPLING POSITION B2
SAMPLING POSITION B4
SAMPLING POSITION B6
SAMPLING POSITION B8

2p
p
p/5

PIXEL VALUE

60
50
40
30
20
10
0
-10

0  2  4  6  8  10  12  14  16  18  20  22  24  26  28  30

PIXEL

—— A
---- B2
—— B4
—·— B6
—··— B8
SENSOR INPUT WAVEFORM

TWO-DIMENSIONAL LPF
(GAUSSIAN FILTER)
*CUT-OFF FREQUENCY: $3\sigma = 1/(4p)$

PIXEL VALUE

1400
1200
1000
800
600
400
200
0

0  2  4  6  8  10  12  14  16  18  20

As, Bs2, Bs4, Bs6, Bs8

PIXEL

FIG. 15

**EP 3 062 065 A1**

## INTERNATIONAL SEARCH REPORT

International application No.

PCT/JP2014/070303

| A. CLASSIFICATION OF SUBJECT MATTER |
|---|
| G01C3/06(2006.01)i, G02B7/28(2006.01)i, G02B7/34(2006.01)i, G03B13/36 (2006.01)i, G06T1/00(2006.01)i, H04N5/232(2006.01)i, H04N9/07(2006.01)i |

According to International Patent Classification (IPC) or to both national classification and IPC

| B. FIELDS SEARCHED |
|---|
| Minimum documentation searched (classification system followed by classification symbols)<br>G01C3/06, G02B7/28, G02B7/34, G03B13/36, G06T1/00, H04N5/232, H04N9/07 |

| Documentation searched other than minimum documentation to the extent that such documents are included in the fields searched |
|---|
| Jitsuyo Shinan Koho 1922–1996 Jitsuyo Shinan Toroku Koho 1996–2014<br>Kokai Jitsuyo Shinan Koho 1971–2014 Toroku Jitsuyo Shinan Koho 1994–2014 |

| Electronic data base consulted during the international search (name of data base and, where practicable, search terms used)<br>IEEE Xplore, SPIE Digital Library |
|---|

C. DOCUMENTS CONSIDERED TO BE RELEVANT

| Category* | Citation of document, with indication, where appropriate, of the relevant passages | Relevant to claim No. |
|---|---|---|
| A | JP 2002-271818 A (Olympus Optical Co., Ltd.), 20 September 2002 (20.09.2002), entire text; all drawings (Family: none) | 1-11 |
| A | JP 2006-24141 A (Sony Corp.), 26 January 2006 (26.01.2006), paragraphs [0005] to [0010] (Family: none) | 1-11 |
| A | JP 2013-44806 A (Olympus Corp.), 04 March 2013 (04.03.2013), entire text; all drawings & WO 2013/027504 A1 | 1-11 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>24 October, 2014 (24.10.14) | Date of mailing of the international search report<br>04 November, 2014 (04.11.14) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/070303

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-124984 A (Canon Inc.), 11 May 2001 (11.05.2001), paragraphs [0053] to [0054] & US 6933978 B1 | 1-11 |
| A | JP 2001-305415 A (Canon Inc.), 31 October 2001 (31.10.2001), paragraphs [0017] to [0021] & US 2001/0036361 A1 | 1-11 |
| P,X P,A | JP 2014-35430 A (Olympus Corp.), 24 February 2014 (24.02.2014), paragraphs [0029] to [0049]; all drawings (Family: none) | 1-4,11 5-10 |
| P,X P,A | JP 2014-38151 A (Olympus Corp.), 27 February 2014 (27.02.2014), paragraphs [0077] to [0087] (Family: none) | 1-4,11 5-10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001022941 A
- JP 2009145401 A